# EUROPÄISCHE PATENTSCHRIFT

(11) **EP 2 191 568 B1**
(45) Veröffentlichungstag und Bekanntmachung des Hinweises auf die Patenterteilung: **05.11.2014**
(21) Anmeldenummer: 08804327.8
(22) Anmeldetag: 17.09.2008
(51) Int. Cl.: H03H 7/01

(54) **FILTERANORDNUNG**
FILTER ARRANGEMENT
SYSTEME DE FILTRAGE

(30) Priorität: 20.09.2007 DE 102007044886
(43) Veröffentlichungstag der Anmeldung: 02.06.2010
(73) Patentinhaber: Gigaset Communications GmbH, 81379 München (DE)
(72) Erfinder: GAPSKI, Dietmar, 46397 Bocholt (DE)
(74) Vertreter: Michalski Hüttermann & Partner Patentanwälte mbB
(86) Internationale Anmeldenummer: PCT/EP2008/062377
(87) Internationale Veröffentlichungsnummer: WO 2009/040282

(56) Entgegenhaltungen:
- WO-A-95/22199
- DE-A1- 1 766 307
- DE-A1- 2 909 260
- JP-A- 2000 124 705
- ITZHAK SHAPIR ED - ITZHAK SHAPIR: "An Improved Narrowband Microwave Bandstop Filter", EUROPEAN MICROWAVE CONFERENCE, 1998. 28TH, IEEE, PISCATAWAY, NJ, USA, 1 October 1998 (1998-10-01), pages 210-214, XP031066977,

## Beschreibung

Die Erfindung betrifft eine Filteranordnung.

Wenn in einem Kommunikationsendgerät zwei Sendeempfänger mit unterschiedlichen Arbeitsfrequenzen gleichzeitig betrieben werden, ist für eine hinreichende sende- und empfangstechnische Isolation zwischen den beiden Sendeempfängern zu sorgen. Dies ist notwendig, um ein einwandfreies Funktionieren der Sendeempfänger zu gewährleisten.

Soll beispielsweise in einem Kommunikationsendgerät gleichzeitig die WLAN-Standardtechnik (WLAN: Wireless Local Area Network) und die DECT-Standardtechnik (DECT: Digital Enhanced Cordless Telecommunication) realisiert sein, welche in benachbarten Frequenzbändern arbeiten, ist unbedingt darauf zu achten, dass der Sendeempfänger der einen Standardtechnik nicht den Sendeempfänger der anderen Standardtechnik stört.

Die DECT-Standardtechnik arbeitet bei 1,89 GHz und die WLAN-Standardtechnik bei 2,45 GHz. Aufgrund dieser nahen Frequenzlage wird ohne das Vorsehen weiterer Maßnahmen der Empfänger der jeweiligen einen Standardtechnik durch den Sender der jeweiligen anderen Standardtechnik regelrecht zugestopft.

Um eine solche gegenseitige negative Beeinflussung zu vermeiden, sind entsprechende Filteranordnungen notwendig, welche die Frequenzen der jeweiligen einen Standardtechnik gegenüber der jeweiligen anderen Standardtechnik sperren. Bezüglich der jeweiligen eigenen Standardtechnik sollen diese Frequenzen jedoch durchgelassen sein.

Üblicherweise sind hierfür Keramikfilteranordnungen eingesetzt, die sehr hochwertig sind. Solche Filteranordnungen können in der weise ausgelegt sein, dass in einem unerwünschten Frequenzbereich ein nachrichtentechnischer Dämpfungspol entsteht, während erwünschte Frequenzen, als Frequenzen im Durchlassbereich, durchgelassen sind.

Sie haben jedoch den Nachteil, relativ teuer zu sein und eine erhöhte Dämpfung im Durchlassbereich zu haben.

Die Durchgangsdämpfung ist so klein wie möglich zu halten. Dies wird durch Filteranordnungen mit hohen Resonatorgüten erreicht. Das Bewerkstelligen der hohen Resonatorgüten ist jedoch ebenfalls teuer.

Allgemein bekannt ist, dass eine am Ende offene Lambda/4 lange Hochfrequenzleitung (Lambda: in der Physik das Formelzeichen unter anderem für die Wellenlänge) aus der Sicht der Eingangsimpedanz einen nachrichtentechnischen Leerlauf in einen nachrichtentechnischen Kurzschluss transformiert.

weiter ist bekannt, eine solche Filteranordnung ausgerichtet auf eine vorgegebene Wellenlänge als selektives Sperrfilter einzusetzen.

Der bereits erwähnte Nachteil, nämlich dass im Durchlassbereich eine erhöhte Durchgangsdämpfung störend wirkt, bleibt bestehen.

Die DE 29 09 260 A1 zeigt einen Sperrfilter für den UHF-Frequenzbereich mit einem durchstimmbaren Resonanzkreis.

Die JP 2000 124705 A beschreibt einen Doppel-Bandfilter basierend auf einer Parallelschaltung eines Pass- oder Sperrfilters mit einem weiteren Filter.

Die DE 17 66 307 A1 zeigt eine Bandfilter-Anordnung mit einer einen Eingang mit einem Ausgang verbindenden Schaltungsanordnung und, wobei an dem Eingang und dem Ausgang jeweils ein Kondensator gegen Masse geschaltet ist.

Der Tagungsbeitrag »Itzhak Shapir: "An Improved Narrowband Microwave Bandstop Fil-ter" European Microwave Conference, 1998. 28th, IEEE, Piscataway, NJ, USA, 1. Oktober 1998, Seiten 210 - 214 « zeigt eine Filteranordnung, die eine Sperrfrequenz und eine entsprechend vorgegebene zu sperrende Wellenlänge und Durchlassbereiche mit Durchlassfrequenzen aufweist, wobei die Filteranordnung einen Hauptstrang aufweist, der von einem Eingang über eine Hochfrequenzleitung zu einem Ausgang führt und an deren Eingang und Ausgang jeweils Lambda/4 lange Hochfrequenzleitungen mit offenem Ende angeschlossen sind.

Aufgabe der vorliegenden Erfindung ist es, kostengünstige Maßnahmen zur sende- und empfangstechnischen Isolation zwischen zwei Sendeempfängern mit zwei unterschiedlichen Arbeitsfrequenzen in einem Kommunikationsendgerät anzugeben.

Diese Aufgabe wird erfindungsgemäß durch eine Verwendung einer Filteranordnung gelöst, die die Merkmale des Anspruchs 1 aufweist.

Erfindungsgemäß wird bezüglich des gewünschten Durchlassbereichs eine Parallelresonanz erzwungen, indem der vorhandene imaginäre Impedanzanteil, beziehungsweise vorhandene Blindanteil, der am Ende offenen Viertelwellenleitung mit einem zweiten, betragsmäßig gleich großen Blindanteil mit entgegengesetztem Vorzeichen kompensiert wird. Dabei hat die am Ende offene Viertelwellenleitung unterhalb ihrer Serienresonanzfrequenz einen negativen Imaginäranteil und oberhalb einen positiven. Demzufolge ist im ersten Fall ein entsprechend großer positiver und im zweiten Fall ein entsprechend großer negativer Blindanteil parallel zu schalten.

Vorteilhaft ist, dass die gesamte Filteranordnung kostengünstig realisiert werden kann. Dies gilt insbesondere dann, wenn die parallel geschalteten Strukturen in Mikrostriptechnologie realisiert sind.

Weiter vorteilhaft ist, dass die Durchgangsdämpfungen in den Durchlassbereichen oberhalb und unterhalb der Serienresonanzfrequenz der Filteranordnung sehr niedrig gemacht sind, da in diesen Bereichen im Gegensatz zu ansonsten üblichen Bandpassfiltern aufgrund der Kompensation der Blindanteile keine Energien mehr gespeichert sind. Das Kurzschlussverhalten der Filteranordnung bleibt dabei unberührt, das heißt, der Sperrfrequenzbereich ist nach wie vor durch das Kurzschlussverhalten der Viertelwellenleitung festgelegt.

Nachfolgend werden Ausführungsbeispiele der Erfindung anhand einer Zeichnung näher erläutert. Darin zeigen:
- Figur 1: ein erstes Ausführungsbeispiel einer erfindungsgemäßen Filteranordnung, ausgelegt für Durchlassfrequenzen kleiner einer zugehörigen Sperrfrequenz,
- Figur 2: eine Filteranordnung gemäß der Figur 1, ausgelegt für Durchlassfrequenzen größer der zugehörigen Sperrfrequenz,
- Figur 3: ein zweites Ausführungsbeispiel einer erfindungsgemäßen Filteranordnung mit einer Sperrfrequenz gemäß der Arbeitsfrequenz gemäß der DECT-Standardtechnik und mit einem Durchlassbereich insbesondere gemäß der Arbeitsfrequenz gemäß der WLAN-Standardtechnik, und
- Figur 4: ein drittes Ausführungsbeispiel einer erfindungsgemäßen Filteranordnung mit einer Sperrfrequenz gemäß der Arbeitsfrequenz gemäß der WLAN-Standardtechnik und mit einem Durchlassbereich insbesondere gemäß der Arbeitsfrequenz gemäß der DECT-Standardtechnik.

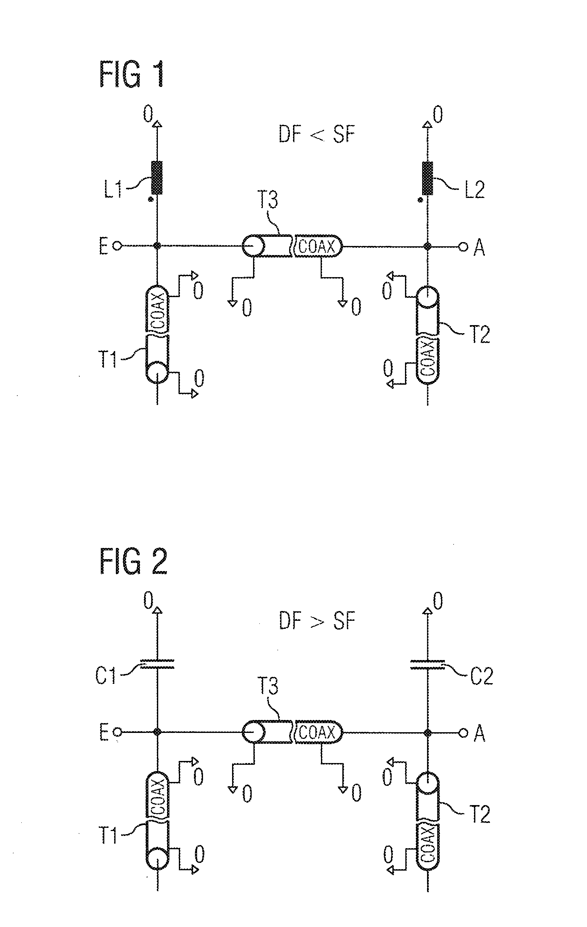

Die Figuren 1 und 2 zeigen erfindungsgemäße Filteranordnungen in einer Realisierung mit Koaxialkabeln COAX, aufgeteilt ausgehend von einer zugehörigen Sperrfrequenz SF in eine jeweilige Ansicht einmal für den Durchlassbereich kleiner der zugehörigen Sperrfrequenz SF und einmal für den Durchlassbereich größer der zugehörigen Sperrfrequenz SF. Dabei spielt die explizite Darstellung der Filteranordnung in den Figuren 1 und 2 keine Rolle. Sie ist lediglich als prinzipielle Schaltungsgestaltung zu verstehen. Die reale Schaltungsgestaltung der erfindungsgemäßen Filteranordnung kann von der hier gezeigten Ausführung abweichen.

Kern der Filteranordnung gemäß den Figuren 1 und 2 ist ein Hauptstrang, der von einem Eingang E über eine Hochfrequenzleitung T3 zu einem Ausgang A führt. Am Eingang E und am Ausgang A sind jeweils Lambda/4 lange Hochfrequenzleitungen T1 beziehungsweise T2 mit offenem Ende angeschlossen. Die jeweiligen zugehörigen Schirmleitungen sind jeweils mit einer Erde 0 verbunden.

Für Durchlassfrequenzen DF kleiner der zugehörigen Sperrfrequenz SF weist die Filteranordnung einen kapazitiven Blindanteil auf, der mit betragsmäßig gleich großen induktiven Blindanteilen kompensiert ist, indem den jeweiligen Lambda/4 langen Hochfrequenzleitungen T1 und T2 entsprechende Induktivitäten L1 und L2 parallel geschaltet sind.

Für Durchlassfrequenzen DF größer der zugehörigen Sperrfrequenz SF weist die Filteranordnung einen induktiven Blindanteil auf, der mit betragsmäßig gleich großen kapazitiven Blindanteilen kompensiert ist, indem den jeweiligen Lambda/4 langen Hochfrequenzleitungen T1 und T2 entsprechende Kapazitäten C1 und C2 parallel geschaltet sind.

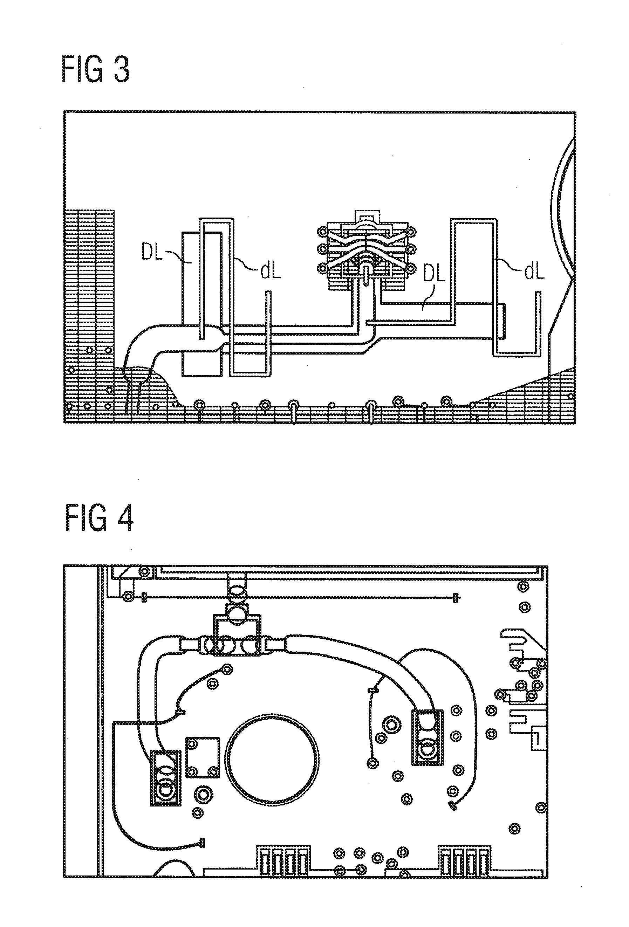

Die Figuren 3 und 4 zeigen praktische Ausführungsbeispiele einer erfindungsgemäßen Filteranordnung in Mikrostriptechnologie auf einer Leiterplatte.

Dabei ist die Filteranordnung gemäß der Figur 3 in der Weise ausgelegt, dass sie die Arbeitsfrequenz gemäß der DECT-Standardtechnik, nämlich 1,89 GHz, sperrt, während sie die Arbeitsfrequenz gemäß der WLAN-Standardtechnik, nämlich 2,45 GHz, durchlässt.

Die Filteranordnung gemäß der Figur 4 ist in der Weise ausgelegt, dass sie die Arbeitsfrequenz gemäß der WLAN-Standardtechnik, nämlich 2,45 GHz, sperrt, während sie die Arbeitsfrequenz gemäß der DECT-Standardtechnik, nämlich 1,89 GHz, durchlässt.

Die Filteranordnung gemäß der Figur 3 ist dahingehend modifiziert, dass die sich kompensierenden Strukturen zweimalig ausgeführt sind, um auf diese Weise eine Verbesserung in der Bandbreitenwirkung zu erzielen.

Die dünnen offenen Leitungsstücke dL bilden dabei die offenen Viertelwellenleitungen, während die dicken offenen Leitungsstücke DL kapazitiv wirken und die dünnen Virtelwellenleitungen dL im WLAN-Frequenzbereich kompensieren.

## Patentansprüche

1. Verwendung einer Filteranordnung zur sende- und empfangstechnischen Isolation zwischen zwei Sendeempfängern mit zwei unterschiedlichen Arbeitsfrequenzen in einem Kommunikationsendgerät, wobei die Filteranordnung als eine Filteranordnung ausgebildet ist, die eine Arbeitsfrequenz sperrende Sperrfrequenz (SF) und eine entsprechend vorgegebene zu sperrende Wellenlänge und einen die andere Arbeitsfrequenz durchlassenden Durchlassbereich mit Durchlassfrequenzen (DF) aufweist, wobei diese Durchlassfrequenzen (DF) kleiner oder größer der Sperrfrequenz (SF) sind, wobei die Filteranordnung einen Hauptstrang aufweist, der von einem Eingang (E) über eine Hochfrequenzleitung (T3) zu einem Ausgang (A) führt und an deren Eingang (E) und Ausgang (A) jeweils Lambda/4 lange Hochfrequenzleitungen (T1, T2) mit offenem Ende angeschlossen sind, wobei
- für einen Durchlassbereich mit Durchlassfrequenzen (DF) kleiner der Sperrfrequenz (SF) den jeweiligen Lambda/4 langen Hochfrequenzleitungen (T1, T2) entsprechende Induktivitäten (L1, L2) parallel geschaltet sind, wodurch ein kapazitiver Blindanteil der restlichen Filteranordnung durch deren betragsmäßig gleich große induktiven Blindanteile kompensiert wird oder
- für einen Durchlassbereich mit Durchlassfrequenzen (DF) größer der Sperrfrequenz (SF) den jeweiligen Lambda/4 langen Hochfrequenzleitungen (T1, T2) entsprechende Kapazitäten (C1, C2) parallel geschaltet sind, wodurch ein induktiver Blindanteil der restlichen Filteranordnung durch deren betragsmäßig gleich große kapazitive Blindanteile kompensiert wird.

2. Verwendung nach Anspruch 1, **dadurch gekennzeichnet, dass** der eine Sendeempfänger mit einer Arbeitsfrequenz bei 1,89 GHz und der andere mit einer Arbeitsfrequenz bei 2,45 GHz betrieben wird, und
wobei die Filteranordnung
- die Arbeitsfrequenz bei 2,45 GHz sperrt und die Arbeitsfrequenz bei 1,89 GHz durchlässt oder
- die Arbeitsfrequenz bei 1,89 GHz, sperrt und die Arbeitsfrequenz bei 2,45 GHz durchlässt.

3. Verwendung nach Anspruch 1 oder 2, **dadurch gekennzeichnet, dass** die Hochfrequenzleitungen (T1, T2, T3) der Filteranordnung als Koaxialkabel (COAX) realisiert sind, deren zugehörigen Schirmleitungen jeweils mit Erde (0) verbunden sind.

4. Verwendung nach Anspruch 1 oder 2, **dadurch gekennzeichnet, dass** die Filteranordnung als eine Filteranordnung in Mikrostrip-Technologie auf einer Leiterplatte ausgebildet ist.

## Claims

1. Use of a filter arrangement for a transmission and reception technological insulation between two transceivers having two different operating frequencies within one communication terminal, wherein the filter arrangement is configured as a filter arrangement comprising a blocking frequency (SF), which blocks one operating frequency, and a corresponding predetermined wavelength to be blocked as well as a pass band with passing frequencies (DF) which passes the other operating frequency, wherein
said passing frequencies (DF) are lower or larger than the blocking frequency (SF), wherein the filter arrangement comprises a main string leading from an input (E) to an output (A) via a high-frequency line (T3), wherein lambda/4 long high-frequency lines (T1, T2) with an open end are respectively connected to the input (E) and the output (A), wherein
- for a pass band with passing frequencies (DF) lower than the blocking frequency (SF) corresponding inductances (L1, L2) are connected parallel to the lambda/4 long high-frequency lines (T1, T2), such that a capacitive reactive component of the remaining filter arrangement is compensated by inductive reactive components equal according to amount, or
- for a pass band with passing frequencies (DF) larger than the blocking frequency (SF) corresponding capacities (C1, C2) are connected parallel to the lambda/4 long high-frequency lines (T1, T2), such that an inductive reactive component of the remaining filter arrangement is compensated by capacitive reactive components equal according to amount.

2. Use according to claim 1, **characterized in that** the one transceiver is operated with an operating frequency at 1,89 GHz and the other with an operating frequency at 2,45 GHz, and
wherein the filter arrangement
- blocks the operating frequency at 2,45 GHz and passes the operating frequency at 1,89 GHz, or
- blocks the operating frequency at 1,89 GHz and passes the operating frequency at 2,45 GHz.

3. Use according to claim 1 or 2, **characterized in that** the high-frequency lines (T1, T2, T3) of the filter arrangement are realized as coaxial cables (COAX), wherein their associated shield conductors are respectively connected to ground (0).

4. Use according to claim 1 or 2, **characterized in that** the fiter arrangement is formed as a filter arrangement in microstrip technology on a circuit board.

## Revendications

1. Utilisation d'un dispositif de filtre pour de l'isolation à de l'émission et à de la réception entre deux émetteurs-récepteurs ayant deux fréquences opératoires différentes dans un appareil émetteur de communication, le dispositif de filtre étant réalisé sous forme d'un dispositif de filtre, qui comporte une fréquence de blocage (SF) bloquant une fréquence opératoire et une longueur d'onde à bloquer prédéterminée de façon correspondante et une zone de passage laissant passer l'autre fréquence opératoire avec des fréquences de passage (DF),
ces fréquences de passage (DF) étant inférieures ou supérieures à la fréquence de blocage (SF), le dispositif de filtre présentant une ligne principale, qui va d'une entrée (E) par un câble à haute fréquence (T3) vers une sortie (A) et à l'entrée (E) et à la sortie (A) de laquelle sont raccordés respectivement des câbles de haute fréquence (T1, T2) d'une longueur lambda/4 à extrémité libre,
- pour une zone de passage ayant des fréquences de passage (DF) inférieures à la fréquence de blocage (SF), des inductances correspondantes (L1, L2) étant connectées parallèlement aux câbles de haute fréquence (T1, T2) respectifs d'une longueur lambda/4, de sorte qu'une partie capacitive aveugle du reste du dispositif de filtre est compensée par ses parties inductives aveugles égales en valeur ou
- pour une zone de passage ayant des fréquences de passage (DE) supérieures à la fréquence de blocage (SF), des capacités correspondantes (C1, C2) étant connectées parallèlement aux câbles de haute fréquence (T1, T2) respectifs d'une longueur lambda/4, de sorte qu'une partie inductive aveugle du reste du dispositif de filtre par ses parties capacitives aveugles égales en valeur.

2. Utilisation selon la revendication 1, **caractérisée en ce que** l'un émetteur récepteur est mis en oeuvre avec une fréquence opératoire de 1,89 GHz et l'autre avec une fréquence opératoire de 2,45 GHz, et
le dispositif de filtre
- bloquant la fréquence opératoire à 2,45 GHz et laissant passer la fréquence opératoire à 1,89 GHz ou
- bloquant la fréquence opératoire à 1,89 GHz et laissant passer la fréquence opératoire à 2,45 GHz.

3. Utilisation selon la revendication 1 ou 2, **caractérisée en ce que** les câbles de haute fréquence (T1, T2, T3) du dispositif de filtre sont réalisés sous forme de câbles coaxiaux (COAX), dont les lignes de blindage correspondantes sont respectivement reliées à la terre (0).

4. Utilisation selon la revendication 1 ou 2, **caractérisée en ce que** le dispositif de filtre est réalisé sous forme d'un dispositif de filtre de technologie microbande sur un circuit imprimé.
